# EUROPÄISCHE PATENTSCHRIFT

(11) **EP 2 041 770 B1**
(45) Veröffentlichungstag und Bekanntmachung des Hinweises auf die Patenterteilung: **12.10.2011**
(21) Anmeldenummer: 07725671.7
(22) Anmeldetag: 30.05.2007
(51) Int. Cl.: H01J 37/256, H01J 37/304, H01J 37/305, G01N 23/225, B01J 19/08, H01L 21/66

(54) **VERFAHREN UND VORRICHTUNG ZUR BEARBEITUNG VON WERKSTÜCKEN**
METHOD AND DEVICE FOR MACHINING WORKPIECES
PROCÉDÉ ET DISPOSITIF D'USINAGE DE PIÈCES

(30) Priorität: 04.07.2006 DE 102006030874
(43) Veröffentlichungstag der Anmeldung: 01.04.2009
(73) Patentinhaber: pro-beam AG & Co. KGaA, 82152 Planegg (DE)
(72) Erfinder: FRIEDBERGER, Alois, 85667 Oberpframmern (DE); LÖWER, Thorsten, 63636 Brachttal (DE); FRICKE, Sören, 72074 Tübingen (DE); SCHMID, Ulrich, 66125 Saarbrücken (DE)
(74) Vertreter: Rasch, Michael
(86) Internationale Anmeldenummer: PCT/EP2007/004781
(87) Internationale Veröffentlichungsnummer: WO 2008/003374

(56) Entgegenhaltungen:
- WO-A-2005/035437
- WO-A2-2005/035437
- GB-A- 1 604 222
- JP-A- 57 087 830
- US-A- 4 008 402
- US-A- 4 203 021
- "3D CHARACTERIZATION BY LOCAL X-RAY EMISSION TOMOGRAPHY" IBM TECHNICAL DISCLOSURE BULLETIN, IBM CORP. NEW YORK, US, Bd. 33, Nr. 1B, 1. Juni 1990 (1990-06-01), Seiten 304-305, XP000122899 ISSN: 0018-8689

## Beschreibung

Die Erfindung betrifft ein Verfahren und eine Vorrichtung zur Bearbeitung eines Werkstücks mittels Elektronenstrahlung.

Bei der Bearbeitung von Werkstücken hat man verschiedene grundlegende Probleme zu bewältigen. Ein erstes Problem besteht darin, das Werkstück exakt zu positionieren, bevor es zum Beispiel materialverändernd bearbeitet werden soll. Eine solche Positionierung kann etwa von der Lage konkreter Oberflächenstrukturen abhängen. Insbesondere bei aus nicht transparenten Werkstoffen bestehenden Werkstücken ist die exakte Positionierung schwierig, wenn sie von der Lage von Oberflächenstrukturen abhängt, die auf der Werkstückrückseite liegen. Das Werkstück muss daher aufwendig vermessen und/oder die Bearbeitungsvorrichtung entsprechend justiert werden.

Ein zweites Problem besteht darin, beim Materialabtrag die verbleibende Materialschichtdicke zu bestimmen. Dieses Problem stellt sich beispielsweise bei der materialabtragenden Werkstückbearbeitung mittels Elektronenstrahl, aber auch zum Beispiel beim nasschemischen Ätzen von Siliziumwafern.

Ein weiteres Problem besteht darin, bei der materialabtragenden Bearbeitung eines mehrschichtigen Werkstücks den Materialabtrag genau dann zu beenden, wenn eine Schichtgrenze erreicht ist.

Die vorliegend offenbarung beruht auf einem gemeinsamen Die vorliegend offenbarung beruth auf einem gemeinsamen Funktionsprinzip, mit dem alle vorgenannten Probleme in einfacher und eleganter Weise lösbar sind. Demzufolge wird das Werkstück auf einer ersten Werkstückseite mit Elektronenstrahlung bestrahlt, die so gewählt ist, dass sie im Material des Werkstücks Röntgenstrahlung erzeugt. Die aus dem Werkstück auf einer der ersten Werkstückseite gegenüberliegenden zweiten Werkstückseite austretende Röntgenstrahlung wird dann detektiert.

Eine Vorrichtung zum Bearbeiten von Werkstücken umfasst demzufolge zusätzlich zu einer Werkstückaufnahme eine entsprechende Elektronenstrahlungsquelle auf einer ersten Seite der Werkstückaufnahme und einen entsprechenden Röntgenstrahlungsdetektor auf einer der ersten Seite gegenüberliegenden zweiten Seite der Werkstückaufnahme gegenüberliegend der Elektronenstrahlungsquelle.

Man macht sich dabei zu Nutze, dass Elektronenstrahlen im Material Röntgenstrahlen erzeugen, die mit einem einfachen Detektor erfasst werden können. Zwar absorbiert das Material die Röntgenstrahlen selbst wieder. Ab einer bestimmten Materialdicke werden die Röntgenstrahlen jedoch nicht mehr vollständig vom Material absorbiert. Indem die auf der Rückseite des Werkstücks austretende Röntgenstrahlung detektiert wird, kann auf die Materialschichtdicke an der betreffenden Stelle zurückgeschlossen werden.

Dieses Prinzip kann einerseits zur Vermessung der Werkstückoberfläche und Bestimmung konkreter Oberflächenstrukturen verwendet werden. In diesem Fall wird die Elektronenstrahlung zweckmäßiger Weise so gering gewählt, dass eine Materialveränderung nicht erfolgt. Vorzugsweise wird ein gebündelter Elektronenstrahl verwendet und damit die Oberfläche der ersten Werkstückseite abgetastet, beispielsweise entlang einer oder mehrerer Linien. An Stellen des Werkstücks, die ausreichend dünn sind, dass die im Werkstück mittels des Elektronenstrahls erzeugte Röntgenstrahlung auf der Werkstückrückseite austritt, lässt sich anhand sich ändernder Röntgenstrahlungsintensitätswerte auf Oberflächenstrukturen zurückschließen, wobei ohne weitere Informationen allerdings keine zuverlässige Aussage darüber zu treffen ist, ob sich die Oberflächenstrukturen auf der Werkstückvorderseite oder auf der Werkstückrückseite oder auf beiden Seiten befinden. Immerhin kann anhand der Höhe der detektierten Röntgenstrahlungsintensität ein Maß für die Schichtdicke und ein Schichtdickenprofil abgeleitet werden, das durch Vergleich mit materialabhängigen Referenzwerten exakt quantifizierbar ist.

Sind zwar die Oberflächenstrukturen auf der Werkstückvorderseite und auf der Werkstückrückseite bekannt, nicht dagegen ihr vertikaler Abstand zueinander und/oder ihre laterale Position relativ zueinander, so lässt sich anhand des ermittelten Dickenprofils sowohl auf ihre relative vertikale als auch auf ihre relative laterale Position zurückschließen. Dies ermöglicht es insbesondere, ein Werkstück lateral exakt zu positionieren, bevor es in irgendeiner Weise weiter bearbeitet wird.

Bei einer (anschließenden) materialabtragenden Werkstückbearbeitung kann das Messprinzip beispielsweise zur Bestimmung einer Restschichtdicke eingesetzt werden. Sobald der Materialabtrag so weit fortgeschritten ist, dass die im Material von der Elektronenstrahlung erzeugte Röntgenstrahlung auf ihrem Weg durch die verbleibende Materialschichtdicke nicht vollständig absorbiert wird, sondern auf der Werkstückrückseite austritt, kann die auf der Werkstückrückseite detektierte Röntgenstrahlungsintensität als Maß für die verbleibende Schichtdicke herangezogen und ausgewertet werden. Sobald die detektierte Röntgenstrahlung einen vorgegebenen Schwellenwert erreicht oder überschreitet, der für das betreffende Material eine bestimmte Materialschichtdicke definiert, kann der Materialabtragungsvorgang beendet werden. Dieses Prinzip ist insbesondere geeignet für Verfahren, bei denen der Materialabtrag mittels des Elektronenstrahls selbst erfolgt. Es ist aber genauso geeignet für andere Verfahren, bei denen der Materialabtrag in anderer Weise erfolgt.

Es ist auch möglich, die jeweils aktuell detektierte Röntgenstrahlung, also den aktuellen Dickenwert, als Stellgröße in einen die Materialabtragung steuernden Regelkreis einfließen zu lassen. Beispielsweise kann die Leistung eines den Materialabtrag bewirkenden Elektronenstrahls in geeigneter Weise reduziert werden, je näher man der gewünschten Materialschichtrestdicke kommt. Die detektierte Röntgenstrahlung ist dabei immer eine Funktion der eingestrahlten Elektronenstrahlintensität pro Fläche, der Materialschichtdicke und des Materials selbst.

Das Dokument GB1604222 offenbart Verbesserungen zum Kontrollieren des Auftreffens eines hochenergetischen Strahls geladener Teilchen auf ein Werkstück und insbesondere ein Verfahren bzw. eine Vorrichtung gemäß der Oberbegriffe der unabhängigen Ansprüche 1 bzw. 8.

Das Dokument US4203021 offenbart ein Verfahren und eine Vorrichtung zur Kontrolle von Verfahrensparametern beim Energiestrahl- (bzw. Elektronenstrahl-) Schweißen.

Das Dokument JP57087830 offenbart ein Ionenätzsystem und schlägt vor, um eine gewünschte Tiefe exakt und gut reproduzierbar zu ätzen, eine Strahlenquelle in Richtung einer Seite einer Probe eines Ionenätzsystems und einen Strahlungsdetektor auf der anderen Seite anzuordnen.

Das Dokument US4008402 offenbart ein Verfahren und eine Vorrichtung zur elektronenstrahlgestützen Ausrichtung eines Teiles durch Detektion von Röntgenstrahlen.

Das Dokument WO2005/035437 offenbart u.a. eine Methode zur hochpräzisen rückgekoppelten Kontrolle der Ionenstrahlbearbeitung von Festkörperstrukturen.

Das Dokument "3D CHARACTERIZATION BY LOCAL X-RAY EMISSION TOMOGRAPHY, IBM TECHNICAL DISCLOSURE BULLETIN, IBM CORP. NEW YORK, US, Bd. 33, Nr. 1B, 1. Juni 1990 (1990-06-01), Seiten 304-305, XP000122899, ISSN: 0018-8689 offenbart die dreidimensionale Charakterisierung mittels lokaler Röntgen-Emissions-Tomographie und schlägt in diesem Zusammenhang im Rahmen seiner Offenbarung insbesondere vor, dass Röntgenstrahlenfilter zwischen Objekt und Detektor dazu benutzt werden könnten, um den Kontrast des Signals zu erhöhen oder um Information über die Elementzusammensetzung der Probe bereitzustellen.

Eine weitere interessante Möglichkeit zur Steuerung eines materialabtragenden Bearbeitungsprozesses mittels des erfindungsgemäßen Prinzips besteht darin, die Materialabtragung in vertikaler Richtung genau dann zu beenden, wenn in einem mehrschichtigen Material eine Schichtgrenze erreicht ist. Dabei wird die physikalische Eigenschaft ausgenutzt, dass das Röntgenspektrum der von der Elektronenstrahlung erzeugten Röntgenstrahlung für unterschiedliche Materialien unterschiedlich ist. Bei Erreichen einer Schichtgrenze ändert sich somit schlagartig die Charakteristik der detektierten Röntgenstrahlung.

Die Erfindung lässt sich somit bei der Werkstückbearbeitung beim Materialabtrag zur vertikalen Positionsbestimmung einsetzen, insbesondere für bei des der Werkstückjustage zur lateralen Positionsbestimmung und dem Materialabtrag zur vertikalen Positionsbestimmung. Sie eignet sich beispielsweise zum Einsatz bei der Herstellung von Mikrokomponenten für die Hochtemperaturdrucksensorik, insbesondere zur Steuerung der Membrandicke beim Ätzen von Silizium und Bestimmung der Membranrestdicke.

Nachfolgend wird dies beispielhaft anhand der begleitenden Zeichnungen erläutert. Darin zeigen:
- Figur 1: schematisch ein Beispiel einer Vorrichtung zum Bearbeiten von Werkstücken, das das Verständnis der Erfindung erleichtert.
- Figur 2: schematisch den Vorgang des Abtastens Werkstücks mittels eines Elektronenstrahls, und
- Figur 3: schematisch den Vorgang des Materialabtragens mittels Elektronenstrahl.

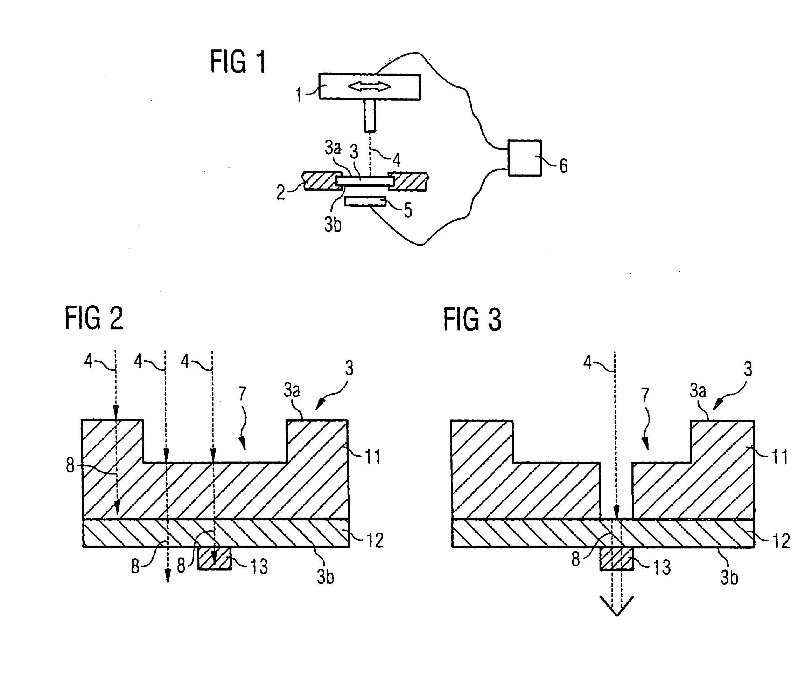

Figur 1 zeigt schematisch den Aufbau einer Vorrichtung zum Bearbeiten von Werkstücken gemäß einem Beispiel, das das Verständnis der Erfindung erleichtert. Die Vorrichtung umfasst ein Elektronenstrahlgerät 1, welches parallel zu einem in einer Werkstückaufnahme 2 aufgenommenen Werkstück 3 verlagerbar ist, um den aus dem Elektronenstrahlgerät 1 austretenden Elektronenstrahl 4 über die Oberfläche einer ersten Seite 3a des Werkstücks 3 bewegen zu können. Die von dem Elektronenstrahl 4 im Werkstoff des Werkstücks 3 erzeugte Röntgenstrahlung wird, soweit sie aus der Rückseite 3b des Werkstücks 3 austritt, mittels eines Röntgenstrahlungsdetektors 5 detektiert, der relativ zur Werkstückaufnahme 2 gegenüberliegend dem Elektronenstrahlgerät 1 angeordnet ist. Das Elektronenstrahlgerät 1 und der Röntgenstrahlungsdetektor 5 sind an eine Auswerteeinrichtung 6 angeschlossen, die unter Berücksichtigung der aktuellen Position des Elektronenstrahlgeräts 1 und der vom Röntgenstrahlungsdetektor 5 detektierten Röntgenstrahlung die Dicke des Werkstücks 3 an der vom Elektronenstrahl 4 zu dem betreffenden Zeitpunkt bestrahlten Stelle des Werkstücks 3 bestimmt. Indem die Elektronenstrahlung als gebündelter Elektronenstrahl 4 an einer definierten Stelle des Werkstücks 3 auftrifft, muss der Röntgenstrahlungsdetektor 5 selbst nicht ortsaufgelöst arbeiten. Zur Ortsauflösung kann die Elektronenstrahlrichtung des Elektronenstrahls 4 beziehungsweise die aktuelle Position des Elektronenstrahlgeräts 1 herangezogen werden.

Mittels der Vorrichtung gemäß Figur 1 kann sowohl die Oberflächenkontur des Werkstücks 3 erfasst werden, indem die Oberfläche 3a mit geeigneter relativ geringer Elektronenstrahlungsintensität abgetastet wird. Dies funktioniert, soweit die Strahlungsintensität ausreichend groß und die Materialdicke ausreichend gering ist, dass mittels des Elektronenstrahls 4 im Werkstück 3 erzeugte Röntgenstrahlung auf der Rückseite 3b des Werkstücks 3 austritt.

Andererseits kann mittels der Vorrichtung gemäß Figur 1 während der materialabtragenden Werkstückbearbeitung die Restdicke des Werkstücks 3 ermittelt werden, insbesondere wenn der Elektronenstrahl 4 selbst die Werkstoffabtragung hervorruft. Aufgrund der ermittelten Restdicke kann der Abtragungsprozess gesteuert und/oder bei einer vorgegebenen Restdicke gestoppt werden.

Figur 2 zeigt schematisch den Vorgang des Abtastens der Oberfläche eines mehrschichtigen Werkstücks 3. Das Werkstück 3 besteht aus insgesamt drei Schichten 11, 12, 13. Die obere Seite 3a des Werkstücks 3, auf welche die Elektronenstrahlung 4 auftrifft, weist eine Vertiefung 7 auf. Die unterste Schicht 13 ist nur lokal im Bereich der Aussparung 7 vorhanden.

Beim Abtasten der Oberfläche 3a mittels des Elektronenstrahls 4 zur Bestimmung der relativen lateralen Lage der unteren lokalen Schicht 13 zur oberen Aussparung 7 überstreicht der Elektronenstrahl 4 von links nach rechts zunächst einen relativ dicken Bereich des Werkstücks 3, in welchem die im Werkstück 3 durch die Elektronenstrahlung 4 erzeugte Röntgenstrahlung 8 auf ihrem Weg zur Werkstückrückseite 3b vollständig absorbiert wird. Sobald der Elektronenstrahl 4 die Aussparung 7 erreicht, ist die Schichtdicke des Werkstücks 3 ausreichend gering, dass die erzeugte Röntgenstrahlung 8 an der Werkstückrückseite 3b austritt und mittels des (in Figur 2 nicht dargestellten) Röntgenstrahldetektors 5 detektiert werden kann. Im weiteren Verlauf überstreicht der Elektronenstrahl 4 die lokale Beschichtung 13. In diesem Abschnitt tritt an der Rückseite 3b des Werkstücks 3 keine Röntgenstrahlung 8 aus, weil sie aufgrund der erhöhten Materialschichtdicke vollständig absorbiert wird. Selbst wenn sie nicht vollständig absorbiert würde, würde die in diesem Abschnitt austretende Röntgenstrahlungsintensität zumindest abnehmen, so dass die relative Lage der lokalen Schicht 13 zur gegenüberliegenden Vertiefung 7 dennoch eindeutig feststellbar wäre. Aufgrund der so ermittelten Vermessungsdaten kann das Werkstück und/oder die Werkstückbearbeitungsvorrichtung zur weiteren Bearbeitung des Werkstücks 3 exakt justiert werden.

Figur 3 zeigt dasselbe Werkstück 3 nach einer materialabtragenden Bearbeitung mittels eines entsprechend stärkeren Elektronenstrahls 4. Da zuvor die exakte relative Lage der lokalen Schicht 13 auf der Werkstückrückseite 3b relativ zur Werkstückvorderseite 3a ermittelt wurde, ist es möglich, die Schicht 11 in exakt dem über der lokalen Schicht 13 liegenden Abschnitt vertikal abzutragen. Dabei wird der (in Figur 3 nicht dargestellte) Röntgenstrahlungsdetektor 5 zunächst eine ständige Zunahme der Röntgenstrahlungsintensität detektieren. Sobald die Schicht 11 bis zur Grenze zur Schicht 12 abgetragen ist, ändert sich das Röntgenstrahlungsspektrum der vom Elektronenstrahl 4 im Werkstück 3 erzeugten Röntgenstrahlung 8 aufgrund des unterschiedlichen Materialverhaltens der Schichten 11 und 12. Dies wird von der Auswerteeinrichtung 6 entsprechend registriert und der weitere Materialabtrag an der konkreten Stelle gestoppt. Der Elektronenstrahl wird solange hin und herbewegt, bis an jeder Stelle des über der lokalen Beschichtung 13 liegenden Abschnitts das Material der Schicht 11 bis zur Schicht 12 abgetragen ist.

## Patentansprüche

1. Verfahren zum Bearbeiten eines Werkstücks (3), umfassend die Schritte:
- Bestrahlen des Werkstücks (3) auf einer ersten Werkstückseite (3a) mit Elektronenstrahlung (4), die so gewählt ist, dass sie im Material des Werkstücks (3) Röntgenstrahlung (8) erzeugt,
- Detektieren von aus dem Werkstück austretender Röntgenstrahlung (8) auf einer der ersten Werkstückseiten (3a) gegenüberliegenden zweiten Werkstückseite (3b), und
- Abtragen von Material des Werkstücks (3) auf der ersten Werkstückseite (3a), wobei
das Abtragen des Materials durch Bestrahlen des Werkstücks (3) mittels der Elektronenstrahlung (4) erfolgt und **dadurch gekennzeichnet, dass** das Abtragen des Materials an einer aktuellen Elektronenstrahlauftreffstelle beendet wird, wenn sich die Charakteristik der detektierten Röntgenstrahlung (8) ändert.

2. Verfahren nach Anspruch 1, **dadurch gekennzeichnet, dass** zum Bestrahlen des Werkstücks (3) mit Elektronenstrahlung (4) ein gebündelter Elektronenstrahl verwendet wird.

3. Verfahren nach Anspruch 2, **dadurch gekennzeichnet, dass** mittels des Elektronenstrahls (4) die Oberfläche der ersten Werkstückseite (3a) abgetastet wird.

4. Verfahren nach Anspruch 3, **gekennzeichnet durch** den Schritt des Zurückschließens auf Oberflächenstrukturen (7, 13) an der ersten und/oder zweiten Werkstückseite (3a/3b) **durch** Auswerten der auf der zweiten Werkstückseite (3b) detektierten Röntgenstrahlung (8).

5. Verfahren nach Anspruch 3, **gekennzeichnet durch** den Schritt der Positionsbestimmung von Oberflächenstrukturen (7) auf der ersten Werkstückseite (3a) relativ zu Oberflächenstrukturen (13) auf der zweiten Werkstückseite (3b) durch Auswerten der auf der zweiten Werk-stückseite (3b) detektierten Röntgenstrahlung.

6. Verfahren nach einem der Ansprüche 1 bis 5, **dadurch gekennzeichnet, dass** die detektierte Röntgenstrahlung (8) als Stellwert in einen die Abtragung des Materials steuernden Regelkreis einfließt.

7. Verfahren nach einem der Ansprüche 2 bis 6, **dadurch gekennzeichnet, dass** zur Ortsauflösung der detektierten Röntgenstrahlung die Elektronenstrahlrichtung des Elektronenstrahls (4) zum Detektionszeitpunkt herangezogen wird.

8. Vorrichtung zum Bearbeiten von Werkstücken (3) umfassend:
eine Werkstückaufnahme (2),
- eine Elektronenstrahlungsquelle (1) auf einer ersten Seite der Werkstückaufnahme (2) zum Bestrahlen eines in der Werkstückaufnahme (2) aufzunehmenden Werkstücks (3) mit Elektronenstrahlung, die so gewählt ist, dass sie im Material des Werkstücks (3) Röntgenstrahlung (8) erzeugt;
- einen Röntgenstrahlungsdetektor (5) auf einer der ersten Seite gegenüberliegenden zweiten Seite der Werkstückaufnahme (2) gegenüber der Elektronenstrahlungsquelle (4) zum Detektieren von aus einem in der Werkstückaufnahme (2) aufzunehmenden Werkstück (3) austretender Röntgenstrahlung (8), und
- Mittel zum Abtragen von Material von einem in der Werkstückaufnahme (2) aufzu-nehmenden Werkstück (3), **gekennzeichnet**
**durch** eine automatische Endabschältung des Materialabtragungsmittel, wenn eine Änderung der Charakteristik der Röntgenstrahlung (8) detektiert wird.

9. Vorrichtung nach Anspruch 8, **gekennzeichnet durch** eine Einrichtung zum Bündeln der Elektronenstrahlung zur Erzeugung eines gebündelten Elektronenstrahls (4).

10. Vorrichtung nach Anspruch 8 oder 9, **dadurch gekennzeichnet, dass** der Elektronenstrahl (4) und die Werkstückaufnahme (2) zum Zweck des Abtastens der Oberfläche eines in der Werkstückaufnahme (2) aufzunehmenden Werkstücks (3) relativ zueinander verlagerbar sind.

11. Vorrichtung nach Anspruch 10, **gekennzeichnet durch** eine Einrichtung (6) zum Auswerten der detektierten Röntgenstrahlung (8) und Zurückschließen auf Oberflächenstrukturen (7, 13) an einer ersten und/oder zweiten Werkstückseite (3a/3b) eines in der Werkstückaufnahme (2) aufzunehmenden Werkstücks.

12. Vorrichtung nach Anspruch 11, **gekennzeichnet durch** eine Einrichtung (6) zum Auswerten der detektierten Röntgenstrahlung (8) und zum Bestimmen der relativen Position, insbesondere lateralen Position, von Oberflächenstrukturen (7) auf einer ersten Werkstück-seite (3a) zu Oberflächenstrukturen (13) auf einer der ersten Werkstückseite gegenüberliegenden zweiten Werkstückseite (3b) eines in der Werkstückaufnahme (2) aufzunehmenden Werkstücks.

13. Vorrichtung nach einem der Ansprüche 8 bis 12, **gekennzeichnet durch** einen das Materialabtragungsmittel steuernden Regelkreis, in den die detektierte Röntgenstrahlung (8) als Stellgröße einfließt.

14. Vorrichtung nach einem der Ansprüche 8 bis 13, **dadurch gekennzeichnet, dass** der. Röntgenstrahlungsdetektor (5), ein nicht-ortsauflösender Detektor ist.

## Claims

1. A method for processing a workpiece (3), comprising the steps:
- irradiation of the workpiece (3) on a first workpiece side (3a) with electron radiation (4), which is selected such that it generates X-radiation in the material of the workpiece (3),
- detection of X-radiation (8) emerging from the workpiece on a second workpiece side (3b) lying opposite the first workpiece side (3a), and
- removal of material of the workpiece (3) on the first workpiece side (3a), wherein the removal of the material takes place by irradiation of the workpiece (3) by means of the electron radiation (4) and
**characterised in that**
the removal of the material is ended at a current electron beam incidence point when the characteristic of the detected X-radiation (8) changes.

2. The method according to claim 1, **characterised in that** a bundled electron beam is used to irradiate the workpiece (3) with electron radiation (4).

3. The method according to claim 2, **characterised in that** the surface of the first workpiece side (3a) is scanned by means of the electron beam (4).

4. The method according to claim 3, **characterised by** the step of deducing the surface structures (7, 13) on the first and/or second workpiece side (3a/3b) by evaluating the X-radiation (8) detected on the second workpiece side (3b).

5. The method according to claim 3, **characterised by** the step of the position determination of surface structures (7) on the first workpiece side (3a) relative to surface structures (13) on the second workpiece side (3b) by evaluating the X-radiation detected on the second workpiece side (3b).

6. The method according to any one of claims 1 to 5, **characterised in that** the detected X-radiation (8) flows as a manipulated variable into a control circuit controlling the removal of the material.

7. The method according to any one of claims 2 to 6, **characterised in that** the electron beam direction of the electron beam (4) to the detection point is used for the spatial resolution of the detected X-radiation.

8. A device for processing a workpiece (3), comprising:
- a workpiece holding fixture (2),
- an electron radiation source (1) on a first side of the workpiece holding fixture (2) for the irradiation of a workpiece (3) to be held in the workpiece holding fixture (2) with electron radiation, which is selected such that it generates X-radiation (8) in the material of the workpiece (3);
- an X-radiation detector (5) on a second side of the workpiece holding fixture (2) lying opposite the first side, opposite the electron radiation source (4) for the detection of X-radiation (8) emerging from a workpiece (3) to be held in the workpiece holding fixture (2), and
- means for removing material from a workpiece (3) to be held in the workpiece holding fixture (2),
**characterised by**
an automatic limit stop of the material removal means, when a change in the characteristic of the X-radiation (8) is detected.

9. The device according to claim 8, **characterised by** a device for bundling the electron radiation in order to generate a bundled electron beam (4).

10. The device according to claim 8 or 9, **characterised in that** the electron beam (4) and the workpiece holding fixture (2) are displaceable relative to one another for the purpose of scanning the surface of a workpiece (3) to be held in the workpiece holding fixture (2).

11. The device according to claim 10, **characterised by** a device (6) for evaluating the detected X-radiation (8) and for deducing the surface structures (7, 13) at a first and/or second workpiece side (3a/3b) of a workpiece to be held in the workpiece holding fixture (2).

12. The device according to claim 11, **characterised by** a device (6) for evaluating the detected X-radiation (8) and for determining the relative position, in particular lateral position, of surface structures (7) on a first workpiece side (3a) with respect to surface structures (13) on a second workpiece side (3b), lying opposite the first workpiece side, of a workpiece to be held in the workpiece fixture (2).

13. The device according to any one of claims 8 to 12, **characterised by** a control circuit controlling the material removal means, into which control circuit the detected X-radiation (8) flows as a manipulated variable.

14. The device according to any one of claims 8 to 13, **characterised in that** the X-radiation detector (5) is a non-spatially resolving detector.

## Revendications

1. Procédé pour l'usinage d'une pièce (3), comprenant les étapes suivantes :
- irradiation de la pièce (3) sur un premier côté de pièce (3a) avec du rayonnement électronique (4), qui est choisi de telle sorte qu'il génère du rayonnement X (8) dans le matériau de la pièce (3),
- détection de rayonnement X (8) sortant de la pièce sur un second côté de pièce (3b), opposé au premier côté de pièce (3a), et
- enlèvement de matériau de la pièce (3) sur le premier côté de pièce (3a),
l'enlèvement du matériau s'effectuant par irradiation de la pièce (3) au moyen du rayonnement électronique (4) et **caractérisé en ce que** l'enlèvement du matériau en un endroit d'impact actuel du faisceau électronique est terminé lorsque la caractéristique du rayonnement X (8) détecté change.

2. Procédé selon la revendication 1, **caractérisé en ce qu'**un faisceau électronique focalisé est utilisé pour l'irradiation de la pièce (3) avec du rayonnement électronique (4).

3. Procédé selon la revendication 2, **caractérisé en ce que** la surface du premier côté de pièce (3a) est balayée au moyen du faisceau électronique (4).

4. Procédé selon la revendication 3, **caractérisé par** l'étape du renvoi à des structures de surface (7, 13) sur le premier et/ou le second côté de pièce (3a/3b) par analyse du rayonnement X (8) détecté sur le second côté de pièce (3b).

5. Procédé selon la revendication 3, **caractérisé par** l'étape de la détermination de la position de structures de surface (7) sur le premier côté de pièce (3a) par rapport à des structures de surface (13) sur le second côté de pièce (3b) par analyse du rayonnement X détecté sur le second côté de pièce (3b).

6. Procédé selon l'une quelconque des revendications 1 à 5, **caractérisé en ce que** le rayonnement X (8) détecté est intégré comme valeur de réglage dans un circuit régulateur commandant l'enlèvement du matériau.

7. Procédé selon l'une quelconque des revendications 2 à 6, **caractérisé en ce que** la direction du faisceau électronique (4) au moment de la détection est utilisée pour la résolution locale du rayonnement X détecté.

8. Dispositif pour l'usinage de pièces (3) comprenant :
- un logement de pièce (2),
- une source de rayonnement électronique (1) sur un premier côté du logement de pièce (2) pour l'irradiation d'une pièce (3) à recevoir dans le logement de pièce (2) avec du rayonnement électronique, qui est choisie de telle sorte qu'elle génère du rayonnement électronique (8) dans le matériau de la pièce (3) ;
- un détecteur de rayonnement X (5) sur un second côté, opposé au premier côté, du logement de pièce (2) par rapport à la source de rayonnement électronique (4) pour la détection de rayonnement X (8) sortant d'une pièce (3) à recevoir dans le logement de pièce (2), et
- des moyens pour l'enlèvement de matériau d'une pièce (3) à recevoir dans le logement de pièce (2),
**caractérisé**
**par** une déconnexion finale automatique du moyen d'enlèvement de matériau lorsqu'un changement de la caractéristique du rayonnement X (8) est détectée.

9. Dispositif selon la revendication 8, **caractérisé par** un dispositif pour la focalisation du rayonnement électronique pour générer un faisceau électronique (4) focalisé.

10. Dispositif selon la revendication 8 ou 9, **caractérisé en ce que** le faisceau électronique (4) et le logement de pièce (2) peuvent être déplacés l'un par rapport à l'autre pour le balayage de la surface d'une pièce (3) à recevoir dans le logement de pièce (2).

11. Dispositif selon la revendication 10, **caractérisé par** un appareil (6) pour l'analyse du rayonnement X (8) détecté et le renvoi à des structures de surface (7, 13) sur un premier et/ou un second côté de pièce (3a/3b) d'une pièce à recevoir dans le logement de pièce (2).

12. Dispositif selon la revendication 11, **caractérisé par** un appareil (6) pour l'analyse du rayonnement X (8) détecté et pour la détermination de la position relative, en particulier de la position latérale, de structures de surface (7) sur un premier côté de pièce (3a) par rapport à des structures de surface (13) sur un second côté de pièce (3b), opposé au premier côté de pièce, d'une pièce à recevoir dans le logement de pièce (2).

13. Dispositif selon l'une quelconque des revendications 8 à 12, **caractérisé par** un circuit régulateur commandant le moyen d'enlèvement de matériau, dans lequel le rayonnement X (8) détecté est intégré comme grandeur de commande.

14. Dispositif selon l'une quelconque des revendications 8 à 13, **caractérisé en ce que** le détecteur de rayonnement X (5) est un détecteur sans résolution locale.
